# EUROPEAN PATENT APPLICATION

(11) **EP 3 859 378 A1**
(43) Date of publication of application: **04.08.2021**
(21) Application number: 19866726.3
(22) Date of filing: 13.09.2019
(51) Int. Cl.: G01S 7/481, G01S 17/87, G02B 26/08, G02B 26/10, H01L 31/0232, H01L 31/10, H01L 33/60, H01S 5/022

(54) **ELECTROMAGNETIC WAVE DETECTION DEVICE AND INFORMATION ACQUISITION SYSTEM**

(30) Priority: 26.09.2018 JP 2018180656
(71) Applicant: Kyocera Corporation, Kyoto-shi, Kyoto 612-8501 (JP)
(72) Inventor: OKADA, Hiroki, Kyoto-shi, Kyoto 612-8501 (JP); TAKEUCHI, Eri, Kyoto-shi, Kyoto 612-8501 (JP)
(74) Representative: Viering, Jentschura & Partner mbB Patent- und Rechtsanwälte
(86) International application number: PCT/JP2019/036217
(87) International publication number: WO 2020/066718

(57) **Abstract**

Simplification of a mechanism for scanning on a measuring object using electromagnetic waves is intended. An electromagnetic wave detection apparatus includes a radiation unit including a plurality of radiation regions capable of radiating electromagnetic waves, a switching unit, and a first detector. The switching unit includes a plurality of switching elements that can be switched to a first state for causing incident electromagnetic waves reflected by an object, from among electromagnetic waves radiated from the radiation unit, to progress in a first direction. The first detector is configured to detect electromagnetic waves progressing in the first direction.

## Description

### CROSS REFERENCE TO RELATED APPLICATION

This application claims priority to and the benefit of Japanese Patent Application No. 2018-180656 filed on September 26, 2018, the entire contents of which are incorporated herein by reference.

### TECHNICAL FIELD

The present disclosure relates to an electromagnetic wave detection apparatus and an information acquisition system.

### BACKGROUND

In recent years, apparatuses configured to acquire information regarding surroundings thereof from a detection result of electromagnetic waves are developed. For example, an apparatus configured to measure a position of an object in an image captured by an infrared camera, using a laser radar is known (see PTL 1).

### CITATION LIST

### Patent Literature

PTL 1: JP-A-2011-220732

### SUMMARY

In order to solve the problems described above, an electromagnetic wave detection apparatus according to a first aspect includes a radiation unit, a switching unit, and a first detector. The radiation unit includes a plurality of radiation regions capable of radiating electromagnetic waves. The switching unit includes a plurality of switching elements that can be switched to a first state for causing incident electromagnetic waves reflected by an object, from among electromagnetic waves radiated from the radiation unit, to progress in a first direction. The first detector is configured to detect electromagnetic waves progressing in the first direction.

Further, an information acquisition system according to a second aspect includes a radiation unit, a switching unit, and a first detector. The radiation unit includes a plurality of radiation regions capable of radiating electromagnetic waves. The switching unit includes a plurality of switching elements that can be switched to a first state for causing incident electromagnetic waves reflected by an object, from among electromagnetic waves radiated from the radiation unit, to progress in a first direction. The first detector is configured to detect electromagnetic waves progressing in the first direction.

Although the apparatus and the system have been described above as the solutions according to the present disclosure, it should be understood that the present disclosure can also be realized by modes that include them, a method or a program that substantially corresponds to them, or a storage medium that stores the program, which are thus included in the scope of the present disclosure.

### BRIEF DESCRIPTION OF THE DRAWINGS

In the accompanying drawings:
FIG. 1 is a diagram illustrating a schematic configuration of an electromagnetic wave detection apparatus according to an embodiment;
FIG. 2 is a diagram illustrating an example configuration of a radiation unit illustrated in FIG. 1;
FIG. 3 is a diagram illustrating another example configuration of the radiation unit illustrated in FIG. 1;
FIG. 4 is a diagram for explaining a scanning mechanism of a scanner illustrated in FIG. 1;
FIG. 5 is a diagram illustrating an example configuration of a switching unit illustrated in FIG. 1;
FIG. 6 is a diagram illustrating an example state of the switching unit illustrated in FIG. 1;
FIG. 7 is a diagram illustrating an example state of the switching unit illustrated in FIG. 1;
FIG. 8 is a diagram illustrating an example state of the switching unit illustrated in FIG. 1;
FIG. 9 is a diagram illustrating an example state of the switching unit illustrated in FIG. 1;
FIG. 10 is a diagram illustrating an example state of the switching unit illustrated in FIG. 1;
FIG. 11 is a diagram illustrating an example state of the switching unit illustrated in FIG. 1;
FIG. 12 is a diagram illustrating an example state of the switching unit illustrated in FIG. 1;
FIG. 13 is a diagram illustrating an example state of the switching unit illustrated in FIG. 1;
FIG. 14 is a diagram illustrating an example state of the switching unit illustrated in FIG. 1;
FIG. 15 is a diagram illustrating an example state of the switching unit illustrated in FIG. 1;
FIG. 16 is a diagram illustrating an example state of the switching unit illustrated in FIG. 1;
FIG. 17 is a diagram illustrating an example state of the switching unit illustrated in FIG. 1;
FIG. 18 is a diagram illustrating an example state of the switching unit illustrated in FIG. 1; and
FIG. 19 is a diagram illustrating a schematic configuration of an example variation of the electromagnetic wave detection apparatus according to the embodiment.

### DETAILED DESCRIPTION

An electromagnetic wave detection apparatus can acquire more detailed information regarding a measuring object by scanning on the measuring object using electromagnetic waves than that acquired by, for example, radiating electromagnetic waves to one spot on the measuring object. Thus, it is useful for the electromagnetic wave detection apparatus to scan on the measuring object using electromagnetic waves.

In a conventional electromagnetic wave detection apparatus, a member capable of deflecting electromagnetic waves scans a measuring object using electromagnetic waves. Because the conventional electromagnetic wave detection apparatus includes such a member, a mechanism for scanning on the measuring object using electromagnetic waves is complicated. Also, the conventional electromagnetic wave detection apparatus is large in size, because of including the member. Further, because a member capable of deflecting electromagnetic waves such as, for example, a biaxial MEMS mirror is costly, the manufacturing cost of the conventional electromagnetic wave detection apparatuses is increased.

As such, an electromagnetic wave detection apparatus according to the present disclosure is configured to simplify the mechanism for scanning on a measuring object using electromagnetic waves, such that the mechanism for scanning the measuring object using electromagnetic waves is simplified. Hereinafter, embodiments according to the present disclosure will be described with reference to the drawings.

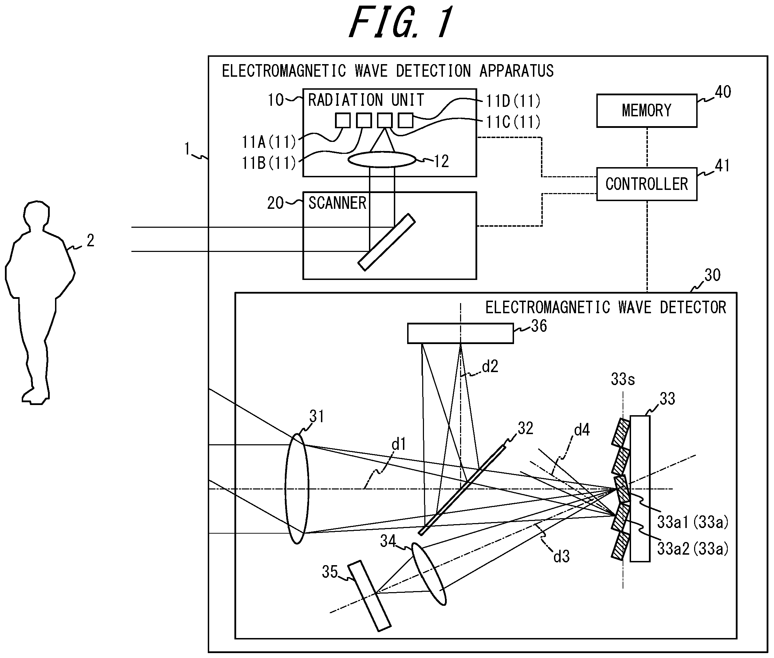

As illustrated in FIG. 1, an electromagnetic wave detection apparatus 1 includes a radiation unit 10 and an electromagnetic wave detector 30. The electromagnetic wave detection apparatus 1 may further include a scanner 20, a memory 40, and a controller 41.

In FIG. 1, a broken line connecting each functional block indicates a flow of a control signal or information. A solid line protruding from each functional block indicates a flow of electromagnetic waves.

The radiation unit 10 radiates electromagnetic waves under the control of the controller 41. The radiation unit 10 may radiate electromagnetic waves in pulses under the control of the controller 41. The electromagnetic waves radiated from the radiation unit 10 are directed to an object 2 via the scanner 20. In a configuration in which the electromagnetic wave detection apparatus 1 does not include the scanner 20, electromagnetic waves may be directly radiated to the object 2 from the radiation unit 10. The radiation unit 10 includes radiation regions 11A, 11B, 11C, and 11D. The radiation unit 10 may further include an optical system 12, depending on configurations of the radiation regions 11A to 11D or the like.

Hereinafter, when the radiation regions 11A to 11D are not distinguished from each other, the radiation regions 11A to 11D will simply be referred to as "radiation region 11". The radiation unit 10 illustrated in FIG. 1 includes four radiation regions 11. Note that the number of radiation regions 11 included in the radiation unit 10 is not limited to four. The number of radiation regions 11 included in the radiation unit 10 may be 3 or less, or 5 or more.

The radiation region 11 can radiate electromagnetic waves. For example, the radiation region 11 may be capable of emitting at least one of infrared rays, visible rays, ultraviolet rays, and radio waves. In the present embodiment, the radiation region 11 can emit infrared rays.

The radiation region 11 may include at least one of a laser diode, a light emitting diode (LED: Light Emitting Diode), a vertical cavity surface emitting laser (VCSEL: Vertical Cavity Surface Emitting Laser), a photonic crystal laser, a gas laser, and a fiber laser. In the present embodiment, the radiation region 11 includes a laser diode (LD: Laser Diode). An example of the laser diode may include a Fabry-Perot laser diode or the like.

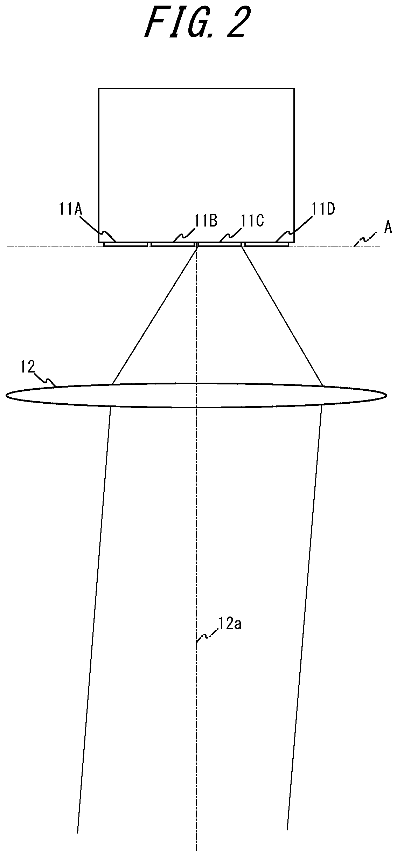

The plurality of radiation regions 11 are arranged in one-dimension. In the present embodiment, the radiation regions 11A to 11D are aligned along a straight line A perpendicular to an optical axis 12a of the optical system 12, as illustrated in FIG. 2. However, an arranging mode of the plurality of radiation regions 11 is not limited to the alignment along the straight line A. For example, the plurality of radiation regions 11 may be aligned along a curved line. Further, the plurality of radiation regions 11 may be arranged in two-dimensions. For example, the plurality of radiation regions 11 may be arranged in a triangular grid shape, a square grid shape, a rectangular grid shape, or a hexagonal grid shape. In a configuration in which the plurality of radiation regions 11 are arranged in two-dimensions, the plurality of radiation regions 11 may be a VCSEL array.

The optical system 12 illustrated in FIG. 2 collimates light emitted by at least one of the radiation regions 11A to 11D. The optical system 12 may include at least one of a lens and a mirror.

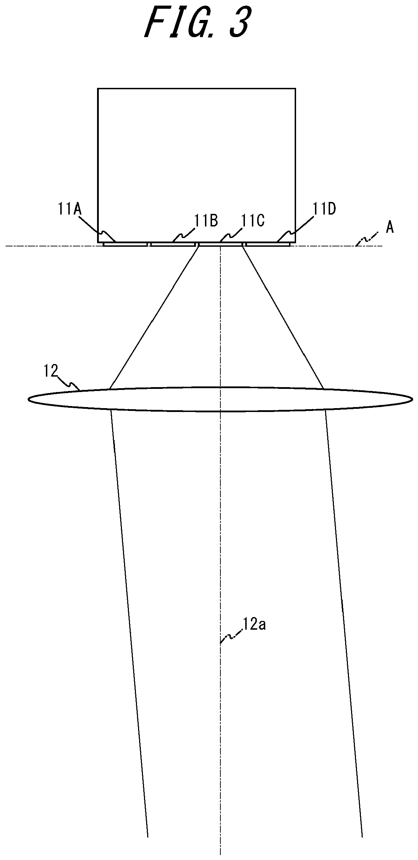

For example, the optical system 12 performs collimation such that light emitted by the radiation region 11C is deflected toward the radiation region 11A, as illustrated in FIG. 2. However, a mode of the optical system 12 is not limited to that illustrated in FIG. 2. For example, depending on a configuration of the optical system 12, the optical system 12 can perform collimation such that light emitted by the radiation region 11C is deflected toward the radiation region 11D, as illustrated in FIG. 3.

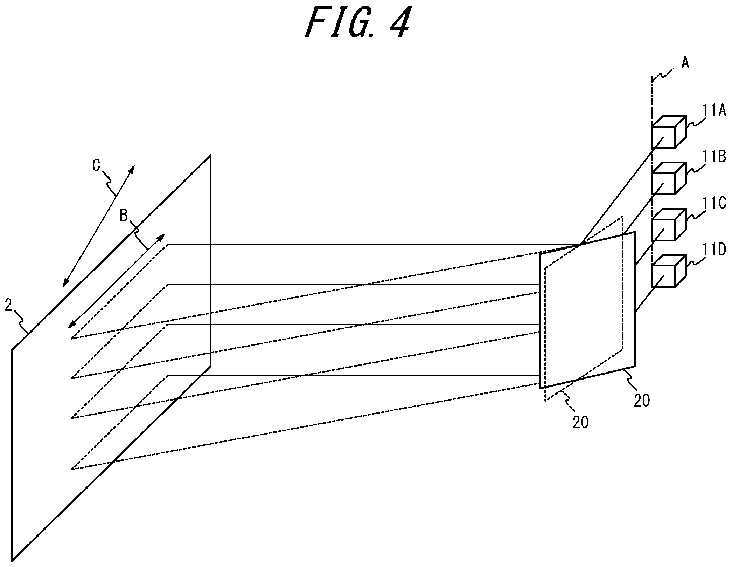

The scanner 20 illustrated in FIG. 1 is configured to change a direction of electromagnetic waves radiated from the radiation unit 10, based on the control by the controller 41. The electromagnetic waves whose direction is changed by the scanner 20 are radiated toward the object 2. In the present embodiment, the scanner 20 is configured to change the direction of electromagnetic waves radiated from the radiation region 11 to a direction B orthogonal to the straight line A as illustrated in FIG. 4, based on the control by the controller 41.

The scanner 20 may include any one of a MEMS mirror, a galvano mirror, and a polygon mirror. A member included in the scanner 20 may be a member capable of polarizing electromagnetic waves in one direction alone. An example of such a member capable of polarizing electromagnetic waves in one direction alone include a uniaxial MEMS mirror, a uniaxial galvano mirror, or a uniaxial polygon mirror.

For example, in a state in which the scanner 20 is fixed, when the radiation regions 11A to 11C sequentially radiate electromagnetic waves, the scanner 20 can scan on the object 2 along a direction parallel to the straight line A using the electromagnetic waves, as illustrated in FIG. 4. Further, the scanner 20 can scan on the object 2 along the direction B using electromagnetic waves by changing a direction of the electromagnetic waves radiated from the radiation region 11, as illustrated in FIG. 4. In this configuration, the present embodiment can scan on the object 2 using electromagnetic waves along the two directions: the direction parallel to the straight line A and the direction B.

In the present embodiment, the scanner 20 may change the direction of electromagnetic waves radiated from the radiation region 11 to a direction that intersects with the straight line A. For example, the scanner 20 may change the direction of electromagnetic waves radiated from the radiation region 11 along a direction C that intersects with the straight line A illustrated in FIG. 4. In this configuration, the scanner 20 can scan on the object 2 using electromagnetic waves along two directions: the direction parallel to the straight line A and the direction C.

The scanner 20 may include an angle sensor such as an encoder. In this configuration, the scanner 20 may notify the controller 41 of an angle detected by the angle sensor as direction information used for reflecting electromagnetic waves. In this configuration, the controller 41 can calculate a radiation position on the object 2, based on the direction information acquired from the scanner 20. Further, the controller 41 can calculate the radiation position on the object 2, based on a drive signal input to cause the scanner 20 to change a direction for reflecting the electromagnetic waves.

As illustrated in FIG. 1, the electromagnetic wave detector 30 includes a front-stage optical system 31, a switching unit 33, a rear-stage optical system 34, and a first detector 35. The electromagnetic wave detector 30 may further include a separator 32 and a second detector 36.

The front-stage optical system 31 forms an image of the object 2. The front-stage optical system 31 may include at least one of a lens and a mirror.

The separator 32 is arranged between the front-stage optical system 31 and a primary image forming position where the front-stage optical system 31 forms an image of the object 2 that is located at a predetermined distance from the front-stage optical system 31. The separator 32 is configured to separate incident electromagnetic waves into electromagnetic waves to progress in a progression direction d1 toward the switching unit 33 and electromagnetic waves to progress in a progression direction d2 (a second direction) toward the second detector 36.

In one embodiment, the separator 32 transmits a part of incident electromagnetic waves in the progression direction d1 and transmits another part of the incident electromagnetic waves in the progression direction d2. The separator 32 may reflect a part of incident electromagnetic waves in the progression direction d2 and transmit another part of the incident electromagnetic waves in the progression direction d1. Further, the separator 32 may refract a part of incident electromagnetic waves in the progression direction d1 and refract another part of the incident electromagnetic waves in the progression direction d2. The separator 32 may include at least one of a half mirror, a beam splitter, a dichroic mirror, a cold mirror, a hot mirror, a metasurface, a deflection element, and a prism.

The switching unit 33 is arranged on a path of electromagnetic waves progressing in the progression direction d1 from the separator 32. Further, the switching unit 33 is located at or in the vicinity of the primary image forming position where the front-stage optical system 31 forms an image of the object 2 that is located at the predetermined distance from the front-stage optical system 31, in the progression direction d1 from the separator 32. In the present embodiment, the switching unit 33 is arranged at the image forming position.

The switching unit 33 has a reference surface 33s on which electromagnetic waves having passed through the front-stage optical system 31 and the separator 32 are to be incident. The reference surface 33s includes a plurality of switching elements 33a arranged in two-dimensions. The reference surface 33s is a surface that causes an action such as, for example, reflection or transmission of electromagnetic waves in at least one of a first state and a second state, which will be described later.

The switching unit 33 can switch electromagnetic waves incident on the reference surface 33s having progressed in the progression direction d1 between the first state for directing the electromagnetic waves to progress in an on-direction d3 (a first direction) and the second state for directing the electromagnetic waves to progress in an off-direction d4 (a third direction), for each of the switching elements 33a. In the present embodiment, the first state is a first reflection state for reflecting the electromagnetic waves incident on the reference surface 33s in the on-direction d3. Also, the second state is a second reflection state for causing the electromagnetic waves incident on the reference surface 33s to progress in the off-direction d4.

In the present embodiment, the switching unit 33 includes a reflection surface for reflecting electromagnetic waves for each of the switching elements 33a. The switching unit 33 switches between the first reflection state and the second reflection state for each of the switching elements 33a by changing a direction of the reflection surface for each of the switching elements 33a.

The switching unit 33 switches each of the switching elements 33a between the first state and the second state, based on the control by the controller 41. For example, the switching unit 33 can cause electromagnetic waves incident on a switching element 33a1 to progress in the on-direction d3 by switching the switching elements 33a1 to the first state, as illustrated in FIG. 1. Simultaneously, the switching unit 33 can cause electromagnetic waves incident on a switching element 33a2 to progress in the off-direction d4 by switching the switching element 33a2 to the second state.

In the present embodiment, the switching unit 33 includes a DMD (Digital Micromirror Device). The DMD can switch between an inclination state in which the reflection surface for each of the switching element 33a is inclined at +12 degrees with respect to the reference surface 33s and an inclination state in which the reflection surface for each of the switching element 33a is inclined at -12 degrees with respect to the reference surface 33s, by driving minute reflection surfaces constituting the reference surface 33s. The reference surface 33s is parallel to a plate surface of a substrate having the minute reflection surfaces of the DMD mounted thereon. The minute reflection surfaces of the DMD are also referred to as micromirror surfaces (micromirrors). In other words, each of the switching elements 33a includes the micromirror surface (the micromirror). Further, the switching element 33a is also referred to as "pixel", because the DMD is generally used as a display element.

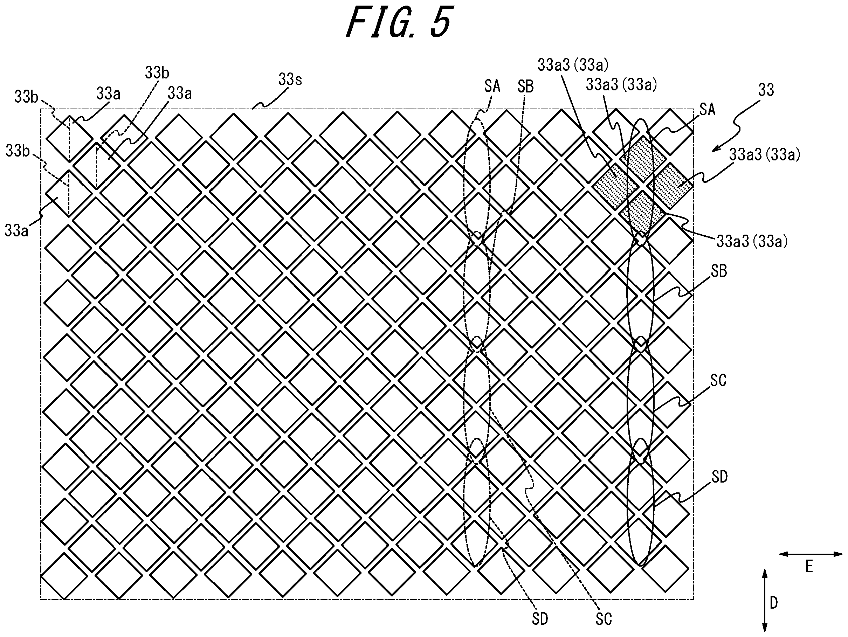

The plurality of switching elements 33a are arranged in two-dimensions on the reference surface 33s, as illustrated in FIG. 5. The plurality of switching elements 33a can be arranged in a square grid pattern. Each of the switching element 33a includes a reflection surface having a quadrangular shape. The switching element 33a includes a rotation axis 33b. The rotation axis 33b extends along a diagonal line of the reflection surface having the quadrangular shape, that is, the micromirror surface. The switching element 33a is rotated about the rotation axis 33b for switching between an inclined state to incline at +12 degrees and an inclined state to incline at -12 ° degrees, with respect to the reference surface 33s. An extending direction of the rotation shaft 33b of the switching element 33a may be appropriately determined in consideration of a location of a detection surface of the first detector 35 illustrated in FIG. 1.

Spots SA, SB, SC, and SD can be formed on the switching unit 33, as illustrated in FIG. 5. The spots SA to SD are spots of electromagnetic waves formed on the switching unit 33 by electromagnetic waves that are incident on the switching unit 33 after being radiated by each of the radiation regions 11A to 11D illustrated in FIG. 1 and reflected by the object 2. In the present embodiment, because the radiation regions 11A to 11D are aligned along the straight line A as illustrated in FIG. 4, a direction D in which the spots SA to SD are arranged extends in a direction along the straight line, as illustrated in FIG. 5. A shape of each of the spots SA to SD may be, for example, an elliptical shape having the direction D as a longitudinal axis or a rectangular shape having longitudinal sides thereof parallel to the direction D, depending on a shape of a portion of the radiation region 11 that emits light. Further, locations of the spots SA to SD in a direction E orthogonal to the direction D can be displaced according to a direction of the scanner 20. For example, when the direction of the scanner 20 is changed, the positions of the spots SAto SD are displaced to positions indicated by broken lines along the direction E.

As described above, the switching element 33a are switched to the first state, based on the control by the controller 41. For example, when a spot SA indicated by a solid line in FIG. 5 is formed on the switching unit 33, four switching elements 33a3 are switched to the first state. Each of the four switching elements 33a3 includes a part of the spot SA. This configuration enables electromagnetic waves having formed the spot SAto be reflected by the four switching elements 33a3 and to progress in the on-direction d3 illustrated in FIG. 1. In the subsequent drawings, the switching elements 33a in the first state are hatched.

The extending direction of the rotation axis 33b of the switching element 33a may extend along the direction D in which the spots SAto SD are lined in FIG. 5. When the extending direction of the rotation axis 33b is along the direction D, electromagnetic waves reflected by the switching unit 33 can progress in a direction perpendicular to the reference surface 33s. In this configuration, by arranging the reference surface 33s and the first detector 35 parallel to each other, electromagnetic waves reflected by the switching unit 33 can progress in the on-direction d3 illustrated in FIG. 1 and can be incident on the first detector 35. In this configuration, by arranging the reference surface 33s and the first detector 35 parallel to each other, the electromagnetic wave detection apparatus 1 can be miniaturized.

As illustrated in FIG. 1, the rear-stage optical system 34 is arranged on a path of electromagnetic waves progressing in the on-direction d3 from the switching unit 33. The rear-stage optical system 34 may include at least one of a lens and a mirror. The rear-stage optical system 34 forms an image of the object 2 as electromagnetic waves whose progression direction is switched by the switching unit 33.

The first detector 35 is arranged on a path of electromagnetic waves progressing via the rear-stage optical system 34 after being caused to progress in the on-direction d3 by the switching unit 33. The first detector 35 detects electromagnetic waves having passed through the rear-stage optical system 34, that is, electromagnetic waves progressing in the on-direction d3 (a first direction).

In the present embodiment, the first detector 35 is an active sensor configured to detect electromagnetic waves reflected by the object 2, from among electromagnetic waves radiated to the object 2 by the radiation unit 10 and the scanner 20.

In the present embodiment, the first detector 35 includes an element constituting a distance measuring sensor. For example, the first detector 35 includes one element such as an APD (Avalanche Photodiode), a PD (Photodiode), or a distance image sensor. The first detector 35 may include an element array such as an APD array, a PD array, a distance imaging array, or a distance image sensor. The first detector 35 may include an image sensor described later or a temperature sensor described later.

In the present embodiment, the first detector 35 transmits detection information indicating that electromagnetic waves reflected by the object 2 are detected, as a signal to the controller 41. The first detector 35 detects electromagnetic waves in the infrared band.

Note that the first detector 35 simply needs to be able to detect electromagnetic waves in a configuration in which the first detector 35 is one element constituting the distance measuring sensor mentioned above. That is, the first detector 35 does not need to form an image on its detection surface. Thus, the first detector 35 does not need to be arranged at a secondary image forming position where the rear-stage optical system 34 forms an image. In this configuration, in other words, the first detector 35 may be arranged at any location on a path of electromagnetic waves that progress via the rear-stage optical system 34 after being caused to progress in the on-direction d3 by the switching unit 33, so long as allowing electromagnetic waves progressing from all angles of view to be incident on the detection surface of the first detector 35.

The second detector 36 is arranged on a path of electromagnetic waves progressing in the progression direction d2 from the separator 32. Further, the second detector 36 is located at or in the vicinity of an image forming position where the front-stage optical system 31 forms an image of the object 2 that is located at a predetermined distance from the front-stage optical system 31, in the progression direction d2 from the separator 32. The second detector 36 detects electromagnetic waves progressing in the progression direction d2 from the separator 32. The second detector 36 detects electromagnetic waves of a different type or the same type as electromagnetic waves detected by the first detector 35.

In the present embodiment, the second detector 36 is a passive sensor. The second detector 36 may be a sensor of a different type or the same type as the first detector 35. The second detector 36 may include an element array. For example, the second detector 36 includes an image sensor or imaging array, captures an image of electromagnetic waves formed on the detection surface, and generates image information corresponding to the captured object 2.

In the present embodiment, the second detector 36 captures an image of visible light. The second detector 36 transmits generated image information as a signal to the controller 41.

The second detector 36 may capture an image of infrared light, ultraviolet, radio waves, or the like rather than an image of visible light. Further, the second detector 36 may include a distance measuring sensor. In this configuration, the electromagnetic wave detection apparatus 1 can acquire distance information in the form of an image using the second detector 36. The second detector 36 may include a temperature sensor or the like. In this configuration, the electromagnetic wave detection apparatus 1 can acquire temperature information in the form of an image using the second detector 36.

The memory 40 illustrated in FIG. 1 may include one or more memories. The memory 40 may function as a primary storage device or a secondary storage device. The memory 40 stores any information and program used for an operation of the electromagnetic wave detection apparatus 1. The memory 40 may be included in the controller 41.

For example, the memory 40 stores position information of the radiation region 11, direction information of the scanner 20, and position information of a spot of electromagnetic waves formed on the switching unit 33 (see FIG. 5), in association with one another. In the configuration in which the electromagnetic wave detection apparatus 1 does not include the scanner 20, the memory 40 may store the position information of the radiation region 11 and the position information of the spot of the electromagnetic waves formed on the switching unit 33 in association with each other. Further, the memory 40 stores the position information of the spot of electromagnetic waves formed on the switching unit 33 in association with position information of a switching element 33a that includes a part of the spot. The memory 40 stores the position information of the switching element 33a that includes a part of the spot as position information of the switching element 33a to be switched to the first state.

The controller 41 illustrated in FIG. 1 includes one or more processors. The processor may include at least one of a general purpose processor configured to read a specific program and perform a specific function, and a specialized processor dedicated for specific processing. The specialized processor may include an ASIC (Application Specific Integrated Circuit). The processor may include a PLD (Programmable Logic Device). The PLD may include an FPGA (Field-Programmable Gate Array). The controller 41 may include at least one of a SoC (System-on-a-Chip) that includes one or more cooperating processors and a SiP (System in a Package).

### Electromagnetic Wave Detection Process

The controller 41 causes at least one of the radiation regions 11A to 11D to radiate electromagnetic waves. The controller 41 causes the switching unit 33 to switch some of the plurality of switching elements 33a to the first state, based on the position information of the spot of electromagnetic waves formed on the switching unit 33 by the electromagnetic waves.

In particular, the controller 41 first determines the radiation region 11 to radiate electromagnetic waves and a direction of the scanner 20. Next, the controller 41 acquires the position information of the spot of electromagnetic waves formed on the switching unit 33 associated with the position information of the radiation region 11 and the direction information of the scanner 20, from the memory 40. For example, when the controller 41 determines that the radiation region 11A among the radiation regions 11 is the radiation region to radiate electromagnetic waves, the controller 41 can acquire position information of the spot SA illustrated in FIG.5. Subsequently, the controller 41 acquires the position information of the switching element 33a to be switched to the first state associated with the position information of the spot of the electromagnetic waves, from the memory 40. For example, the controller 41 can acquire position information of the four switching elements 33a3 associated with the position information of the spot SA illustrated in FIG. 5, from the memory 40. The controller 41 causes the switching unit 33 to switch the switching element 33a whose position information is acquired as the switching element 33a to be switched to the first state to the first state. Further, the controller 41 causes the switching unit 33 to maintain (switch) the switching element 33a whose position information is not acquired as the switching element 33a to be switched to the first state in (to) the second state. For example, the controller 41 causes the switching unit 33 to switch the four switching elements 33a3 illustrated in FIG. 5 to the first state and to maintain the switching elements 33a other than the switching elements 33a3 illustrated in FIG. 5 in the second state. This configuration enables the electromagnetic waves having formed the spot SA illustrated in FIG. 5 to be reflected by the switching elements 33a3, to progress in the on-direction d3 illustrated in FIG. 1, and then to be incident on the first detector 35 illustrated in FIG. 1. Further, by maintaining the switching elements 33a other than the switching elements 33a3 in the second state as illustrated in FIG. 5, incidence of ambient light on the first detector 35 illustrated in FIG. 1 can be suppressed.

There are various patterns for the control described above. Hereinafter, other examples of such various patterns will be described.

### Example 1

The controller 41 may cause the radiation regions 11A to 11D to sequentially radiate electromagnetic waves. Further, the controller 41 may cause the switching unit 33 to switch some of the switching elements 33a to the first state, based on the position information of the spots of electromagnetic waves to be sequentially formed on the switching unit 33 by the electromagnetic waves. By sequentially radiating electromagnetic waves from the radiation regions 11A to 11D as described above, electromagnetic waves can scan on the object 2 along the direction parallel to the straight line A, as illustrated in FIG. 4. Further, the controller 41 may cause the scanner 20 to change the direction thereof after causing the radiation regions 11A to 11D to sequentially radiate electromagnetic waves. By changing the direction of the scanner 20 as described above, electromagnetic waves can scan on the object 2 along the direction B, as illustrated in FIG. 4. Hereinafter, an example of this control will be described.

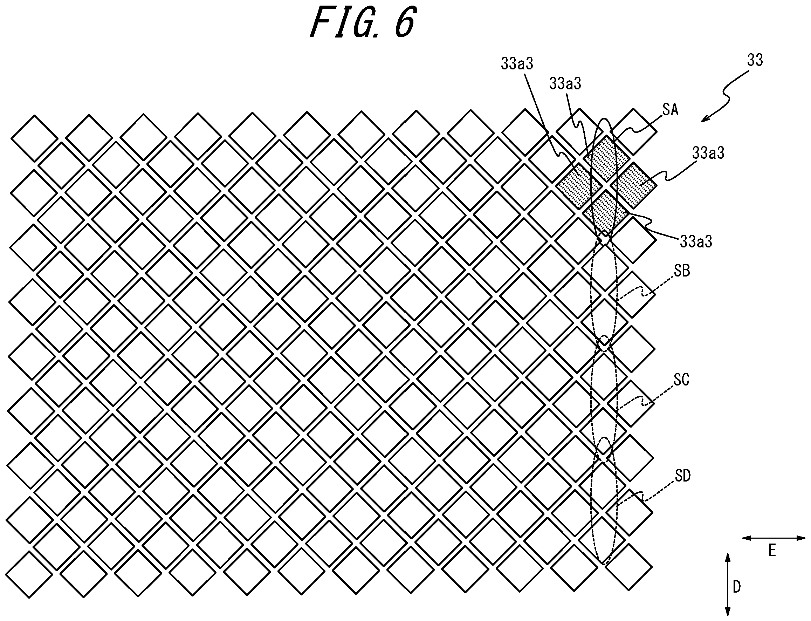

First, the controller 41 causes the radiation region 11A to radiate electromagnetic waves. When the radiation region 11A radiates electromagnetic waves, the spot SA is formed as illustrated in FIG. 6. In this configuration, the controller 41 causes the switching unit 33 to switch the four switching elements 33a3 illustrated in FIG. 6 to the first state. Each of the four switching elements 33a3 includes a part of the spot SA. In this configuration, further, the controller 41 causes the switching unit 33 to switch the switching elements 33a other than the four switching elements 33a3 illustrated in FIG. 6 to the second state. This configuration enables electromagnetic waves having formed the spot SA to be reflected by the switching elements 33a3, to progress in the on-direction d3 illustrated in FIG. 1, and then to be incident on the first detector 35 illustrated in FIG. 1. Further, by setting the switching elements 33a other than the switching elements 33a3 to the second state, incidence of ambient light on the first detector 35 illustrated in FIG. 1 can be suppressed.

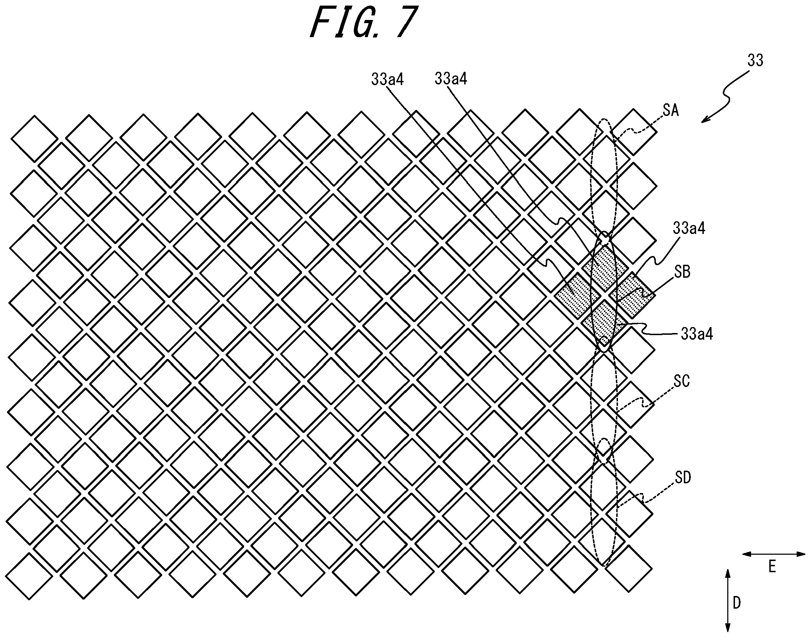

Next, the controller 41 causes the radiation region 11B to radiate electromagnetic waves. When the radiation region 11B radiates electromagnetic waves, a spot SB is formed as illustrated in FIG. 7. In this configuration, the controller 41 causes the switching unit 33 to switch four switching elements 33a4 illustrated in FIG. 7 to the first state. Each of the four switching elements 33a4 includes a part of the spot SB. In this configuration, further, the controller 41 causes the switching unit 33 to switch the switching elements 33a other than the four switching elements 33a4 illustrated in FIG. 7 to the second state. This configuration enables electromagnetic waves having formed the spot SB to be reflected by the switching elements 33a4, to progress in the on-direction d3 illustrated in FIG. 1, and then to be incident on the first detector 35 illustrated in FIG. 1. Further, by setting the switching elements 33a other than the switching elements 33a4 to the second state, incidence of ambient light on the first detector 35 illustrated in FIG. 1 can be suppressed.

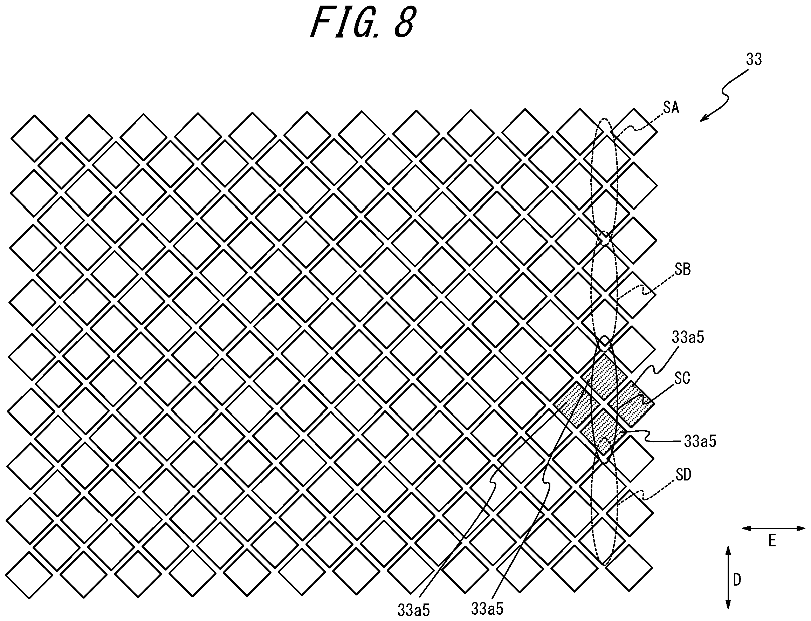

Subsequently, the controller 41 causes the radiation region 11C to radiate electromagnetic waves. When the radiation region 11C radiates electromagnetic waves, a spot SC is formed as illustrated in FIG. 8. In this configuration, the controller 41 causes the switching unit 33 to switch four switching elements 33a5 illustrated in FIG. 8 to the first state. Each of the four switching elements 33a5 includes a part of the spot SC. In this configuration, further, the controller 41 causes the switching unit 33 to switch the switching elements 33a other than the four switching elements 33a illustrated in FIG. 8 to the second state. This configuration enables electromagnetic waves having formed the spot SC to be reflected by the switching elements 33a5, to progress in the on-direction d3 illustrated in FIG. 1, and then to be incident on the first detector 35 illustrated in FIG. 1. Further, by setting the switching elements 33a other than the switching elements 33a5 to the second state, incidence of ambient light on the first detector 35 illustrated in FIG. 1 can be suppressed.

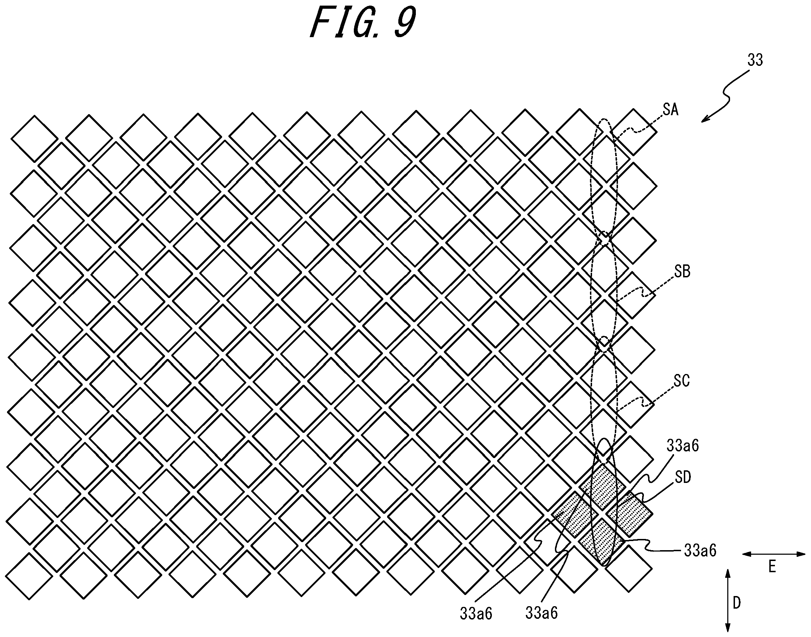

Subsequently, the controller 41 causes the radiation region 11D to radiate electromagnetic waves. When the radiation region 11D radiates electromagnetic waves, a spot SD is formed as illustrated in FIG. 9. In this configuration, the controller 41 causes the switching unit 33 to switch four switching elements 33a6 illustrated in FIG. 9 to the first state. Each of the four switching elements 33a6 includes a part of the spot SD. In this configuration, further, the controller 41 causes the switching unit 33 to switch the switching elements 33a other than the four switching elements 33a6 illustrated in FIG. 9 to the second state. This configuration enables electromagnetic waves having formed the spot SD to be reflected by the switching elements 33a6, to progress in the on-direction d3 illustrated in FIG. 1, and then to be incident on the first detector 35 illustrated in FIG. 1. Further, by setting the switching elements 33a other than the switching elements 33a6 to the second state, incidence of ambient light on the first detector 35 illustrated in FIG. 1 can be suppressed.

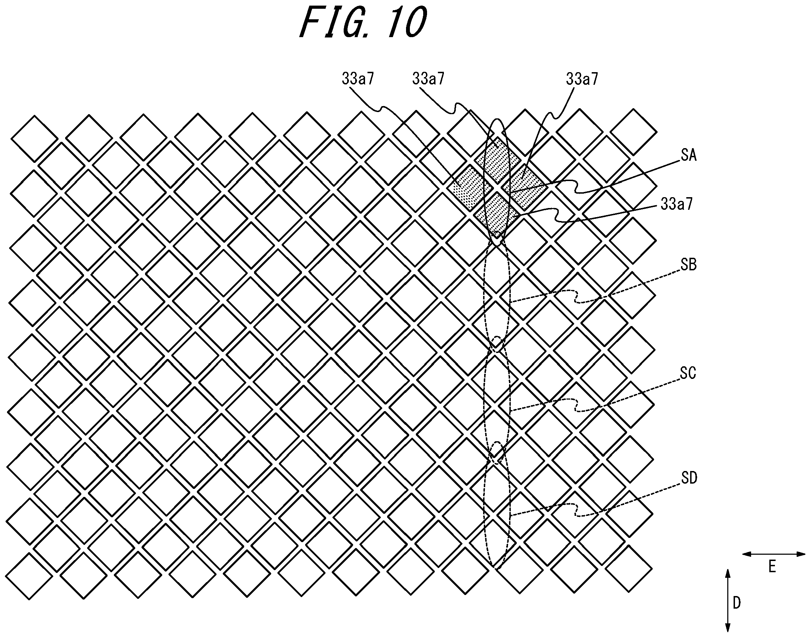

Then, the controller 41 causes the scanner 20 to change the direction thereof. Further, the controller 41 once again causes the radiation regions 11A to 11D to sequentially radiate electromagnetic waves. The controller 41 first causes the radiation region 11A to radiate electromagnetic waves, in the same manner as that described above with reference to FIG. 6. When the radiation region 11A radiates electromagnetic waves, the spot SA is formed as illustrated in FIG. 10. A position of the spot SA illustrated in FIG. 10 is displaced along the direction E from the position of the spot SA illustrated in FIG. 6. In this configuration, the controller 41 causes four switching elements 33a7 illustrated in FIG. 10 to be switched to the first state. Each of the four switching elements 33a7 includes a part of the spot SA. In this configuration, further, the controller 41 causes the switching unit 33 to switch the switching elements 33a other than the four switching elements 33a7 illustrated in FIG. 10 to the second state. This configuration enables electromagnetic waves having formed the spot SA to be reflected by the switching elements 33a7, to progress in the on-direction d3, and then to be incident on the first detector 35. Further, by setting the switching elements 33a other than the switching elements 33a7 to the second state, incidence of ambient light on the first detector 35 illustrated in FIG. 1 can be suppressed. Then, the controller 41 causes the radiation regions 11B to 11D to sequentially radiate electromagnetic waves, in the same manner as that described above with reference to FIG. 7 to FIG. 9.

The controller 41 repeatedly performs the control described above. By repeatedly performing the control described above using the controller 41, the electromagnetic wave detection apparatus 1 can scan on the object 2 using electromagnetic waves along the two directions: the direction parallel to the straight line A and the direction B, as illustrated in FIG. 4.

### Example 2

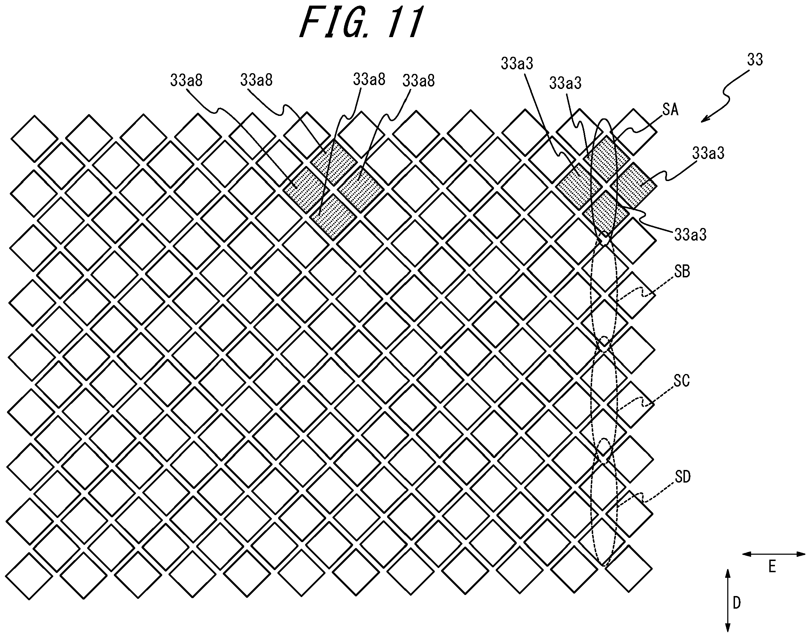

The controller 41 may cause the switching unit 33 to switch the switching elements 33a in a plurality of predetermined regions to the first state in advance, based on position information of a spot of electromagnetic waves formed on the switching unit 33. The plurality of predetermined regions may be located along the direction E orthogonal to the direction D. For example, the controller 41 may cause the four switching elements 33a3 and four switching elements 33a8 located along the direction E to be switched to the first state in advance, as illustrated in FIG. 11.

In a configuration illustrated in FIG. 11, the controller 41 first causes the radiation region 11A to radiate electromagnetic waves. When the radiation region 11A radiates electromagnetic waves, the spot SA is formed as illustrated in FIG 11. Electromagnetic waves having formed the spot SA can be reflected by the switching element 33a3, can progress in the on-direction d3, and can then be incident on the first detector 35. Subsequently, the controller 41 may quickly switch the switching elements 33a3 to the second state.

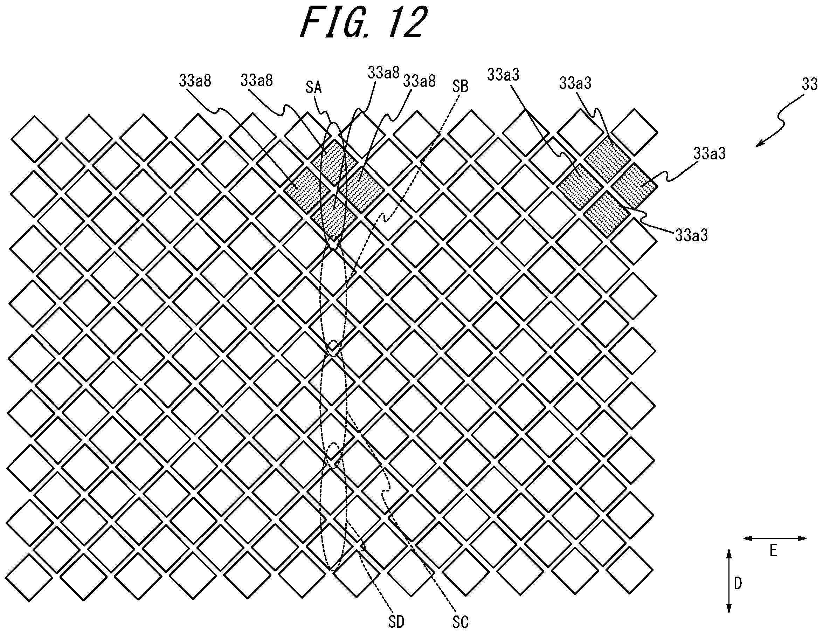

Then, the controller 41 causes the scanner 20 to change the direction of the electromagnetic waves radiated by the radiation region 11A. By causing the scanner 20 to change the direction of the electromagnetic waves radiated by the radiation region 11A, the spot SA is displaced along the direction E as illustrated in FIG. 12. Electromagnetic waves having formed the spot SA illustrated in FIG. 12 can be reflected by the switching elements 33a8, can progress in the on-direction d3 illustrated in FIG. 1, and can then be incident on the first detector 35 illustrated in FIG. 1. Subsequently, the controller 41 may quickly switch the switching elements 33a8 to the second state.

Switching the switching elements 33a in the plurality of predetermined regions to the first state in advance as described above eliminates the necessity for the controller 41 to cause the switching unit 33 to change the switching elements 33a to the first state or the second state each time the scanner 20 changes the direction. This configuration enables efficient scanning on the object 2 along the direction B using electromagnetic waves as illustrated in FIG. 4.

### Example 3

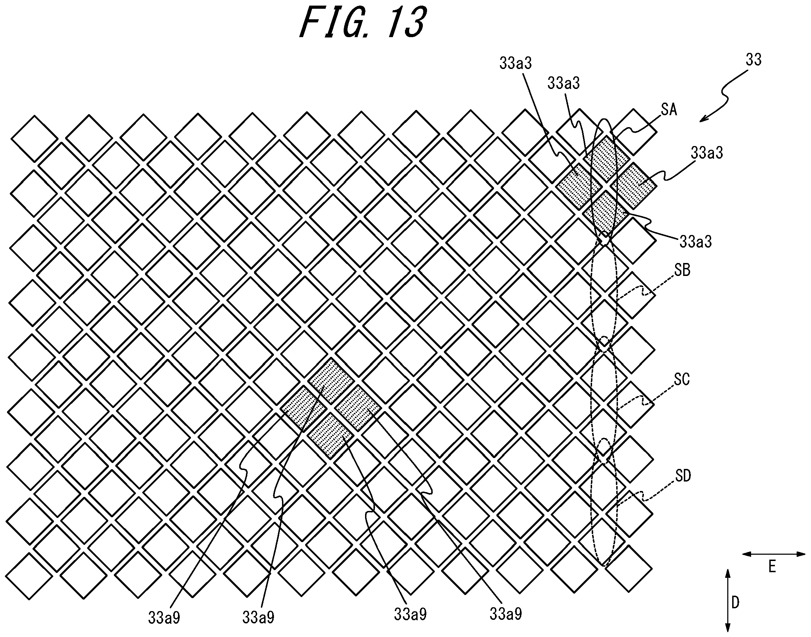

The controller 41 may cause the switching unit 33 to switch switching elements 33a in a plurality of predetermined regions to the first state in advance, based on position information of a spot of electromagnetic waves formed on the switching unit 33. The plurality of predetermined regions may be located along a diagonal direction with respect to the direction D. For example, the controller 41 may switch the four switching elements 33a3 and four switching elements 33a9 that are located along the diagonal direction with respect to the direction D to the first state in advance, as illustrated in FIG. 13.

In a configuration illustrated in FIG. 13, the controller 41 first causes the radiation region 11A to radiate electromagnetic waves, such that the spot SA is formed as illustrated in FIG. 13. Electromagnetic waves having formed the spot SA can be reflected by the switching elements 33a3, can progress in the on-direction d3, and can then be incident on the first detector 35. Subsequently, the controller 41 may quickly switch the switching elements 33a3 to the second state.

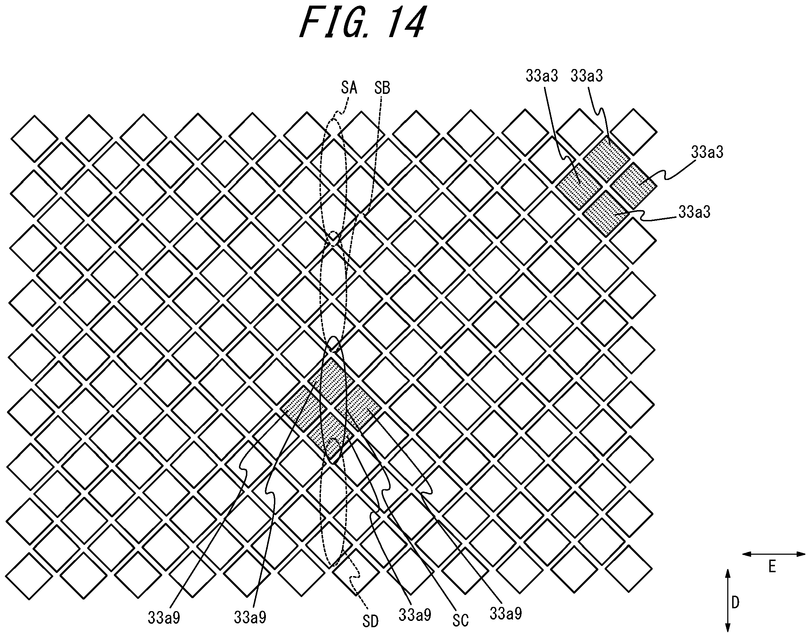

Next, the controller 41 changes the direction of the scanner 20 and causes the radiation region 11C to radiate electromagnetic waves. By changing the direction of the scanner 20 and radiating electromagnetic waves from the radiation region 11C, the spot SC is formed as illustrated in FIG. 14. Electromagnetic waves having formed the spot SC illustrated in FIG. 14 can be reflected by the switching elements 33a9, can progress in the on-direction d3 illustrated in FIG. 1, and can then be incident on the first detector 35 illustrated in FIG. 1. Subsequently, the controller 41 may quickly switch the switching elements 33a9 to the second state.

Switching the switching elements 33a in the plurality of predetermined regions to the first state in advance as described above eliminates the necessity for the controller 41 to cause the switching unit 33 to change the switching elements 33a to the first state or the second state each time the controller 41 changes the direction of the scanner 20 and changes the radiation region 11 to radiate electromagnetic waves. This configuration enables efficient scanning on the object 2 using electromagnetic waves. Further, this configuration enables scanning on the object 2 using electromagnetic waves from different radiation regions 11A and 11C, as illustrated in FIG. 13 and FIG. 14. In other words, the object 2 can be scanned by electromagnetic waves without continuously using the same radiation region 11. This configuration can suppress heat generation by the radiation region 11 caused by continuously using the same radiation region 11.

### Example 4

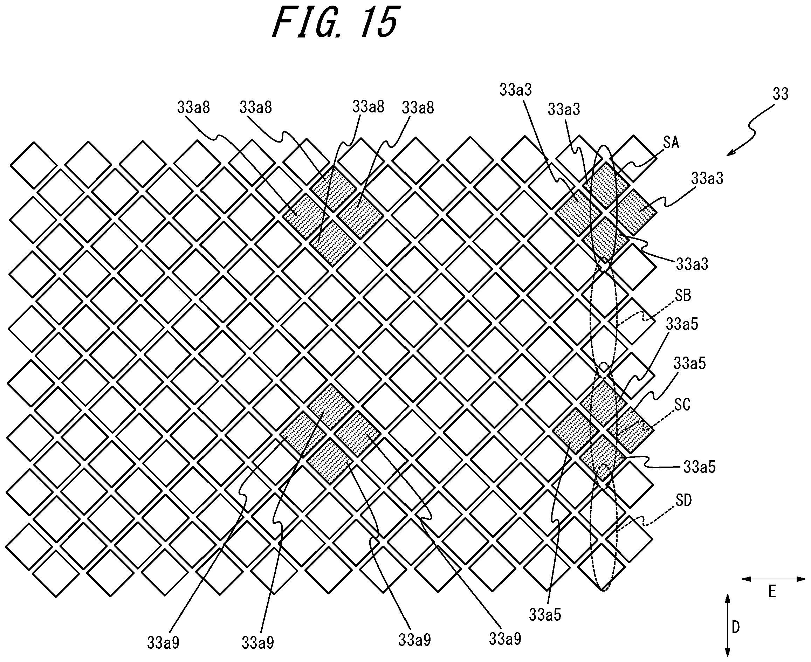

The controller 41 may cause the switching unit 33 to switch switching elements 33a in a plurality of predetermined regions to the first state in advance, based on position information of a spot of electromagnetic waves formed on the switching unit 33. A part of the plurality of predetermined regions may be located along the direction D. Another part of the plurality of predetermined areas may be located along the direction E. For example, the controller 41 may switch the four switching elements 33a3, the four switching elements 33a5, the four switching elements 33a8, and the four switching elements 33a9 to the first state in advance, as illustrated in FIG. 15.

In a configuration illustrated in FIG. 15, the controller 41 first causes the radiation region 11A to radiate electromagnetic waves such that the spot SA is formed as illustrated in FIG. 15. Electromagnetic waves having formed the spot SA can be reflected by the switching elements 33a3, can progress in the on-direction d3, and can then be incident on the first detector 35. Subsequently, the controller 41 may quickly switch the switching elements 33a3 to the second state.

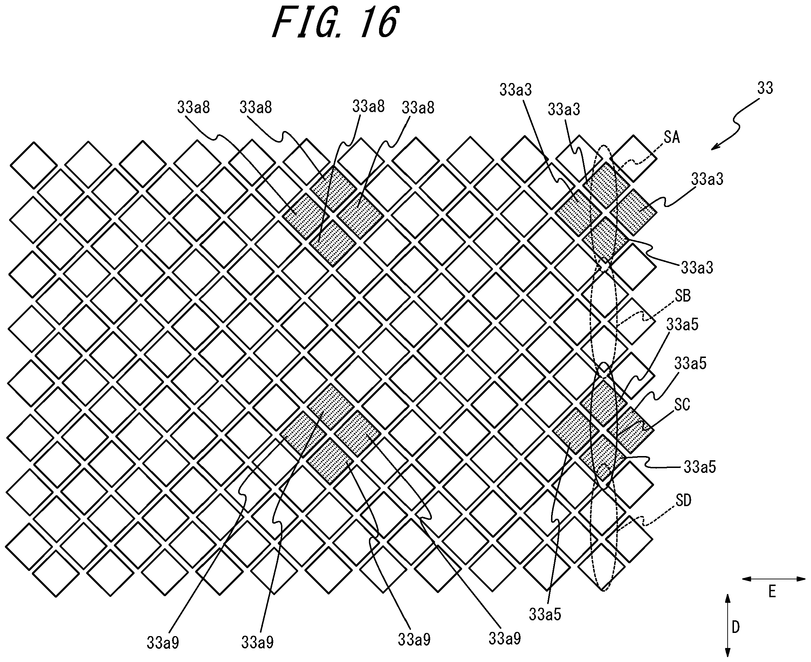

Next, the controller 41 causes the radiation region 11C to radiate electromagnetic waves such that the spot SC is formed as illustrated in FIG. 16. Electromagnetic waves having formed the spot SC illustrated in FIG. 16 can be reflected by the switching elements 33a5, can progress in the on-direction d3 illustrated in FIG. 1, and can then be incident on the first detector 35 illustrated in FIG. 1. Then, the controller 41 may quickly switch the switching elements 33a5 to the second state.

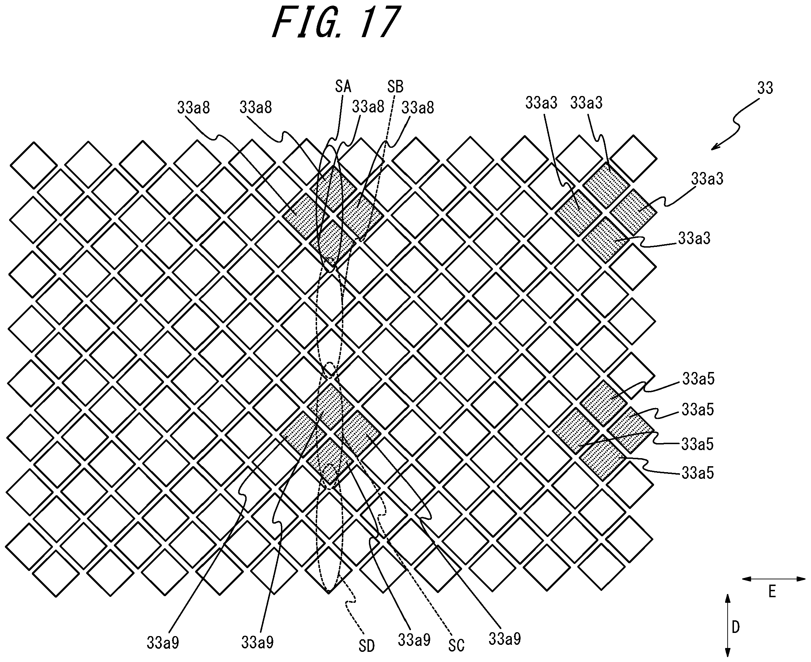

Subsequently, the controller 41 changes the direction of the scanner 20 and causes the radiation region 11A to radiate electromagnetic waves. By changing the direction of the scanner 20 and radiating electromagnetic waves from the radiation region 11A, the spot SA is formed as illustrated in FIG. 17. Electromagnetic waves having formed the spot SA illustrated in FIG. 17 can be reflected by the switching elements 33a8, can progress in the on-direction d3 illustrated in FIG. 1, and can then be incident on the first detector 35 illustrated in FIG. 1. Subsequently, the controller 41 may quickly switch the switching elements 33a8 to the second state.

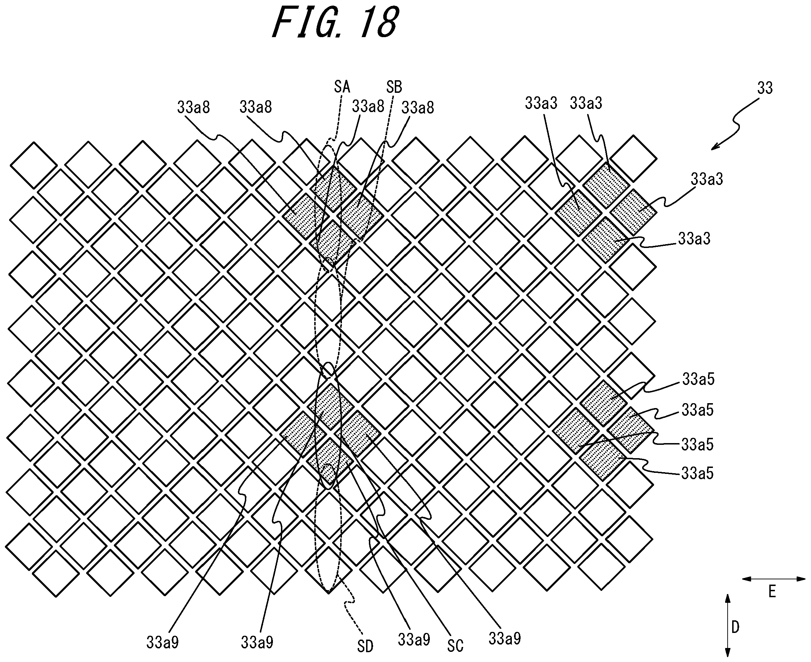

Then, the controller 41 causes the radiation region 11C to radiate electromagnetic waves. When the radiation region 11C radiates electromagnetic waves, the spot SC is formed as illustrated in FIG. 18. Electromagnetic waves having formed the spot SC illustrated in FIG. 18 can be reflected by the switching element 33a9, can progress in the on-direction d3 illustrated in FIG. 1, and can then be incident on the first detector 35 illustrated in FIG. 1. Subsequently, the controller 41 may quickly switch the switching elements 33a9 to the second state.

Switching the switching elements 33a in the plurality of predetermined regions to the first state in advance as described above eliminates the necessity for the controller 41 to cause the switching unit 33 to switch the switching elements 33a to the first state or the second state each time the controller 41 changes the direction of the scanner 20 and changes the radiation region 11 to radiate electromagnetic waves. This configuration enables efficient scanning on the object 2 using electromagnetic waves along the two directions (the direction parallel to the straight line A and the direction B), as illustrated in FIG. 4.

### Surrounding Information Acquisition Operation

The controller 41 acquires information regarding the surroundings of the electromagnetic wave detection apparatus 1, based on electromagnetic waves detected by each of the first detector 35 and the second detector 36. The information regarding the surroundings is, for example, image information, distance information, temperature information, or the like. The controller 41 acquires the image information using the second detector 36. Further, the controller 41 acquires the distance information using the first detector 35, as will be described later.

For example, the controller 41 acquires the distance information using a ToF (Time-of-Flight) method. In this configuration, the controller 14 may include a time measurement LSI (Large Scale Integrated circuit). By using the time measurement LSI, the controller 41 measures a time ΔT from time at which the radiation unit 10 is caused to radiate electromagnetic waves to time at which the detection information is acquired by the first detector 35. The controller 41 calculates a distance to the radiation position on the object 2 by multiplying the measured time ΔT by the speed of light and then dividing an acquired result by 2. The controller 41 calculates the radiation position of electromagnetic waves, based on the direction information acquired from the scanner 20, the drive signal output to the scanner 20 by the controller 41, or a drive signal output to each of the radiation regions 11A to 11D. The controller 41 acquires the distance information in the form of an image by calculating the distance to each radiation position while changing the radiation position of electromagnetic waves.

In the present embodiment, the electromagnetic wave detection apparatus 1 is configured to acquire distance information using Direct ToF that directly measures time from radiation of electromagnetic waves to return of the electromagnetic waves. However, the configuration of the electromagnetic wave detection apparatus 1 is not limited thereto. For example, the electromagnetic wave detection apparatus 1 may acquire distance information using Flash ToF that indirectly measures time from radiation of electromagnetic waves at fixed intervals to return of the electromagnetic waves, based on a phase difference between the radiated electronic waves and the returned electromagnetic waves. Alternatively, the electromagnetic wave detection apparatus 1 may acquire distance information using another ToF method such as, for example, Phased ToF.

As described above, the electromagnetic wave detection apparatus 1 according to the present embodiment includes the radiation unit 10 that includes the radiation regions 11A to 11D serving as the plurality of radiation regions 11, and the switching unit 33. This configuration enables scanning on the object 2 using electromagnetic waves by causing the radiation regions 11A to 11D to sequentially radiate electromagnetic waves, without deflecting the direction of electromagnetic waves using, for example, a reflector or the like. In other words, the electromagnetic wave detection apparatus 1 according to the present embodiment can realize simplification of the mechanism for scanning on the measuring object using electromagnetic waves.

Also, in the electromagnetic wave detection apparatus 1 according to the present embodiment, the radiation regions 11A to 11D can be aligned along the straight line A, as illustrated in FIG. 4. Further, the electromagnetic wave detection apparatus 1 according to the present embodiment may include the scanner 20 configured to change the direction of electromagnetic waves radiated from the radiation regions 11A to 11D to the direction B orthogonal to the straight line A, as illustrated in FIG. 4. The electromagnetic wave detection apparatus 1 according to the present embodiment configured as described above can scan on the object 2 using electromagnetic waves along the two directions: the direction along the straight line A and the direction B. By scanning on the object 2 along the two directions using electromagnetic waves, the electromagnetic wave detection apparatus 1 according to the present embodiment can acquire more detailed information regarding the surroundings than that acquired in a case in which the scanning is performed in one direction. Further, the electromagnetic wave detection apparatus 1 according to the present embodiment can scan on the object 2 along the two directions using electromagnetic waves, by means of the scanner 20 constituted of a member capable of polarizing electromagnetic waves in one direction alone, such as the uniaxial MEMS mirror. The member capable of changing the direction of electromagnetic waves in one direction alone can be at lower cost than a member capable of changing the direction of electromagnetic waves in two directions alone, such as the biaxial MEMS mirror. Accordingly, the present embodiment can realize the configuration to scan on the object 2 along two directions using electromagnetic waves at low cost.

In the electromagnetic wave detection apparatus 1 according to the present embodiment, further, the controller 41 can cause the switching elements 33a in a plurality of predetermined regions to be switched to the first state in advance, based on a position of a spot formed on the switching unit 33. Switching the switching elements 33a in the plurality of predetermined regions to the first state in advance eliminates the necessity for the controller 41 to cause the switching unit 33 to switch switching elements 33a corresponding to the position of the spot to the first state each time the spot formed on the switching unit 33 is displaced. This configuration enables the electromagnetic wave detection apparatus 1 according to the present embodiment to efficiently scan on the object 2 using electromagnetic waves.

Although the embodiments according to the present disclosure have been described based on the figures and the examples, it should be apparent to those skilled in the art that various modifications and alterations can be made without departing from the present disclosure. Accordingly, such modifications and alterations are to be included in the scope of the present disclosure.

In the present embodiment, for example, the radiation unit 10, the scanner 20, the electromagnetic wave detector 30, the memory 40, and the controller 41 have been described to constitute the electromagnetic wave detection apparatus 1. However, the information acquisition system may be configured using an apparatus that includes the radiation unit 10 and the scanner 20 and an apparatus that includes the electromagnetic wave detector 30. The information acquisition system configured in this manner may further include the memory 40 and the controller 41.

In the present embodiment, further, the switching unit 33 has been described as to be able to switch the progression direction of electromagnetic waves incident on the reference surface 33s to the two directions: the on-direction d3 and the off-direction d4. However, the switching unit 33 may be able to switch the progression direction to three or more directions, rather than to one of the two directions.

In the present embodiment, further, the first state has been described to be the first reflection state for reflecting electromagnetic waves incident on the reference surface 33s in the on-direction d3, and the second state has been described to be the second reflection state for reflecting the electromagnetic waves incident on the reference surface 33s in the off-direction d4. However, the first state and the second state may refer to other modes.

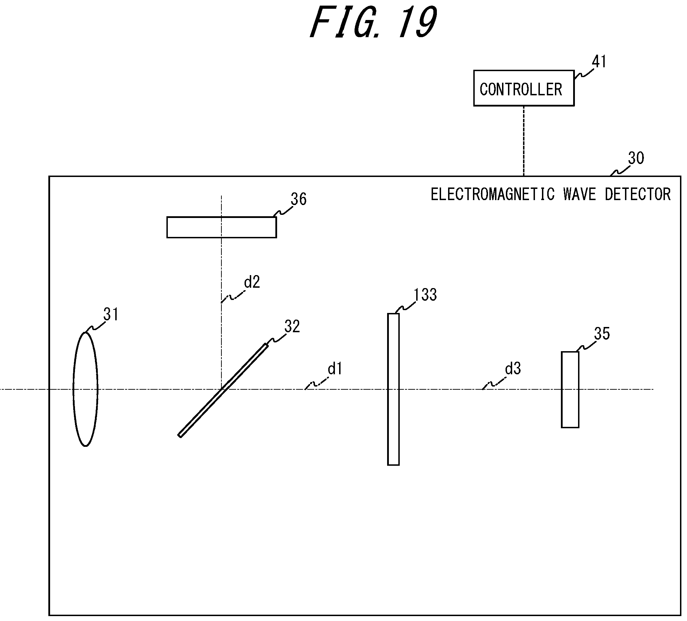

For example, the first state may be a transmission state in which electromagnetic waves incident on the reference surface 33s are transmitted to progress in the on-direction d3, as illustrated in FIG. 19. In this configuration, a switching unit 133 may include a shutter having a reflection surface that reflects electromagnetic waves in the off-direction d4 for each of the switching elements 33a. The switching unit 133 configured as described above switches each of the switching elements 33a between the transmission state serving as the first state and the reflection state serving as the second state, by opening and closing the shutter for each of the switching elements 33a.

An example of the switching unit 133 configured as described above includes a switching unit that includes a MEMS shutter in which a plurality of shutters that can be opened and closed are arranged in an array. Further, the switching unit 133 may be a switching unit that includes a liquid crystal shutter capable of switching between a reflection state for reflecting electromagnetic waves and a transmission state for transmitting electromagnetic waves, according to a liquid crystal alignment. The switching unit 133 configured as described above can switch between the reflection state serving as the first state and the transmission state serving as the second state for each of the switching elements 33a by switching the liquid crystal alignment for each of the switching elements 33a.

In the present embodiment, further, the electromagnetic wave detection apparatus 1 has been described to include the first detector 35 as an active sensor and the second detector 36 as a passive sensor. However, the configuration of the electromagnetic wave detection apparatus 1 is not limited thereto. For example, in a case in which the electromagnetic wave detection apparatus 1 has a configuration in which both the first detector 35 and the second detector 39 serve as active sensors or passive sensors, an effect similar to that of the present embodiment can be obtained. In a configuration in which both the first detector 35 and the second detector 39 serve as active sensors, either the radiation unit 10 or respective radiation units 10 may radiate electromagnetic waves to the object 2. Further, the respective radiation units 10 may radiate electromagnetic waves of the same type or different types.

### REFERENCE SIGNS LIST

1 electromagnetic wave detection apparatus
10 radiation unit
11, 11A, 11B, 11C, 11D radiation region
12 optical system
20 scanner
30 electromagnetic wave detector
31 front-stage optical system
32 separator
33, 133 switching unit
33s reference surface
33a, 33a1, 33a2, 33a3, 33a3, 33a4, 33a5, 33a6, 33a7, 33a8, 33a9 switching element
34 rear-stage optical system
35 first detector
36 second detector
40 memory
41 controller
d1 progression direction (first direction)
d2 progression direction
d3 on-direction (second direction)
d4 off-direction (third direction)
SA, SB, SC, SD spot
A, B, C, D, E direction

## Claims

1. An electromagnetic wave detection apparatus comprising:
a radiation unit including a plurality of radiation regions capable of radiating electromagnetic waves;
a switching unit including a plurality of switching elements that can be switched to a first state for causing incident electromagnetic waves reflected by an object, from among electromagnetic waves radiated from the radiation unit, to progress in a first direction; and
a first detector configured to detect electromagnetic waves progressing in the first direction.

2. The electromagnetic wave detection apparatus according to claim 1,
wherein at least some of the plurality of radiation regions are arranged in one-dimension.

3. The electromagnetic wave detection apparatus according to claim 1 or 2,
wherein at least some of the plurality of radiation regions are arranged in two-dimensions.

4. The electromagnetic wave detection apparatus according to any one of claims 1 to 3,
wherein at least some of the plurality of radiation regions are aligned along a straight line, and
the electromagnetic wave detection apparatus further comprising a scanner configured to change a direction of electromagnetic waves radiated from the radiation regions aligned along the straight line to a direction intersecting with the straight line.

5. The electromagnetic wave detection apparatus according to claim 4,
wherein the scanner is configured to change a direction of electromagnetic waves radiated from the radiation regions aligned along the straight line to a direction orthogonal to the straight line.

6. The electromagnetic wave detection apparatus according to claim 4 or 5,
wherein the scanner includes one of a MEMS mirror, a galvano mirror, and a polygon mirror.

7. The electromagnetic wave detection apparatus according to any one of claims 1 to 6, further comprising:
a controller configured to cause at least one of the plurality of radiation regions to radiate electromagnetic waves and, based on position information of a spot of the electromagnetic waves formed on the switching unit by the electromagnetic waves, cause the switching unit to switch some of the plurality of switching elements to the first state.

8. The electromagnetic wave detection apparatus according to claim 7,
wherein the controller is configured to cause the plurality of radiation regions to sequentially radiate electromagnetic waves and, based on position information of spots of the electromagnetic waves sequentially formed on the switching unit, cause the switching unit to sequentially switch some of the plurality of switching elements to the first state.

9. The electromagnetic wave detection apparatus according to claim 7,
wherein the controller is configured to cause the switching unit to switch the switching elements in a plurality of predetermined regions to the first state in advance, based on the position information of the spot of the electromagnetic waves formed on the switching unit.

10. The electromagnetic wave detection apparatus according to any one of claims 1 to 9,
wherein a radiation region includes at least one of a laser diode, a light emitting diode, a vertical resonator surface emitting laser, a photonic crystal laser, a gas laser, and a fiber laser.

11. The electromagnetic wave detection apparatus according to any one of claims 1 to 10, further comprising:
a separator configured to separate incident electromagnetic waves into electromagnetic waves to progress in a direction toward the switching unit and electromagnetic waves to progress in a second direction; and
a second detector configured to detect electromagnetic waves progressing in the second direction.

12. The electromagnetic wave detection apparatus according to claim 11,
wherein the separator includes at least one of a half mirror, a beam splitter, a dichroic mirror, a cold mirror, a hot mirror, and a metasurface.

13. The electromagnetic wave detection apparatus according to claim 11 or 12,
wherein each of the first detector and the second detector includes at least one of a distance measuring sensor, an image sensor, and a temperature sensor.

14. The electromagnetic wave detection apparatus according to any one of claims 11 to 13,
wherein the first detector and the second detector are configured to detect electromagnetic waves of the same type or different types.

15. The electromagnetic wave detection apparatus according to any one of claims 11 to 14,
wherein each of the first detector and the second detector is configured to detect at least one of infrared rays, visible rays, ultraviolet rays, and radio waves.

16. The electromagnetic wave detection apparatus according to any one of claims 1 to 15,
wherein the switching unit is configured to switch incident electromagnetic waves reflected by the object to a first reflection state for reflecting the electromagnetic waves in a first direction and a second reflection state for reflecting the electromagnetic waves in a third direction, for each switching element.

17. The electromagnetic wave detection apparatus according to claim 16,
wherein the switching unit includes a reflection surface that reflects electromagnetic waves for each switching element and is configured to switch between the first reflection state and the second reflection state by deflecting a direction of the reflection surface for each switching element.

18. The electromagnetic wave detection apparatus according to claim 16 or 17,
wherein the switching unit includes a digital micromirror device.

19. The electromagnetic wave detection apparatus according to claim 18,
wherein the switching element includes a micromirror of the digital micromirror device, and
a rotation axis of the micromirror extends along a direction in which spots of electromagnetic waves formed on the switching unit by electromagnetic waves reflected by the object and incident on the switching unit are lined.

20. The electromagnetic wave detection apparatus according to any one of claims 1 to 18,
wherein the switching unit is configured to switch incident electromagnetic waves reflected by the object between a transmission state for transmitting the electromagnetic waves in the first direction and a reflection state for reflecting the electromagnetic waves in a third direction, for each switching element.

21. The electromagnetic wave detection apparatus according to claim 20,
wherein the switching unit includes a shutter including a reflection surface for reflecting electromagnetic waves for each switching element and is configured to switch between the reflection state and the transmission state by opening and closing the shutter for each switching element.

22. The electromagnetic wave detection apparatus according to claim 21,
wherein the switching unit includes a MEMS shutter in which shutters are arranged in an array.

23. The electromagnetic wave detecting apparatus according to claim 20 or 21,
wherein the switching unit includes a liquid crystal shutter capable of switching between a reflection state for reflecting electromagnetic waves and a transmission state for transmitting electromagnetic waves, in accordance with a liquid crystal alignment.

24. An information acquisition system comprising:
a radiation unit including a plurality of radiation regions capable of radiating electromagnetic waves;
a switching unit including a plurality of switching elements that can be switched to a first state for causing incident electromagnetic waves reflected by an object, from among electromagnetic waves radiated from the radiation unit, to progress in a first direction; and
a first detector configured to detect electromagnetic waves progressing in the first direction.
